Europäisches Patentamt

European Patent Office

Office européen des brevets

(11) Veröffentlichungsnummer: **0 419 725 A1**

## (12) EUROPÄISCHE PATENTANMELDUNG

(21) Anmeldenummer: 89118084.6

(22) Anmeldetag: 29.09.89

(51) Int. Cl.5: **G01R 1/067**

(43) Veröffentlichungstag der Anmeldung:
**03.04.91 Patentblatt 91/14**

(84) Benannte Vertragsstaaten:
**AT BE CH DE ES FR GB GR IT LI LU NL SE**

(71) Anmelder: **Siemens Aktiengesellschaft**
Wittelsbacherplatz 2
W-8000 München 2(DE)

(72) Erfinder: **Moschüring, Hugo, Dr.-Ing.**
Buchenstrasse 23
W-8011 Höhenkirchen/Siegertsbrunn(DE)

(54) **Messplatz für Mikrowellenbauelemente.**

(57) Ein Meßplatz für ein Mikrowellenbauelement mit einem Träger (10) für das Mikrowellenbauelement und mit mindestens einer Meßspitze (5) soll die zerstörungsfreie Bestimmung der Eigenschaften von Mikrowellenschaltungen auf möglichst kleinen Substratflächen auch bei der Messung von quasi-planaren Schaltungen mit Anschlußleitungen in unsymmetrischer Mikrostreifenleitungs-Technik ermöglichen. Die räumlichen Positionen der mindestens einen Meßspitze (5) sind in den drei Raumrichtungen bezüglich der räumlichen Position des Trägers (10) veränderbar und justierbar.

FIG 1

EP 0 419 725 A1

## MESSPLATZ FÜR MIKROWELLENBAUELEMENTE

Die Erfindung betrifft einen Meßplatz nach dem Oberbegriff des Patentanspruchs 1. Die Erfindung bezieht sich auf eine Anordnung zur Messung sowohl von analogen als auch von digitalen, hybrid oder monolithisch aufgebauten Schaltungen in quasi-planarer Leitungstechnik mit Trägermaterialien (Substraten) möglichst kleiner Oberfläche. Eine kleine Oberfläche weisen z. B. Einzel-Halbleiter-Bauelemente wie z. B. gehäuste oder ungehäuste Transistoren, z. B. MESFET, ferner Komponenten wie hybrid aufgebaute oder monolithisch integrierte Mikrowellenschaltungen (MMIC) oder kombinierte Anordnungen wie Chip-Carrier-Aufbauten auf.

Bisher erfolgt die Messung von gehäusten Transistoren mit geeigneten Meßaufnahmen, in denen die Anschlußbändchen der Transistoren über planare Leitungsstrukturen kontaktiert werden. Ungehäuste Transistoren werden bisher in Meßfassungen mit Steg geprüft. Dieses Meßverfahren ist wegen der irreversiblen Kontaktierung mit Hilfe von Bonddraht und Lot nicht zerstörungsfrei. Die gemessenen Transistoren können deshalb im allgemeinen nicht weiter verwendet werden. Die Messung kompletter monolithisch integrierter Schaltungen aus GaAs-Material hat ebenfalls die für die Messung der ungehäusten Transistoren angegebenen Nachteile. Diese Messung ist nicht zerstörungsfrei und aufwendig und deshalb weder zur Messung einzelner Komponenten noch zur Messung einer großen Zahl von Elementen, wie es bei der Ausgangsprüfung bei einer Fertigung von Bauelementen notwendig ist, geeignet.

Es gibt einen Meßplatz (Fa. Cascade Microtech, Inc.) zur Messung von planaren Schaltungen auf einem Halbleiter-Wafer. Dieser Meßplatz ist mit Meßspitzen in koplanarer Leitungstechnik ausgestattet. Die Messung eines Bauelements mit dieser Art von Meßspitzen erfordert auf dem Bauelement eine Anschlußkonfiguration in koplanarer Leitungstechnik (ohne Grundmetallisierung) oder erfordert Durchkontaktierungen auf dem Halbleiter-Wafer. Eine Messung von einzelnen integrierten Schaltungen auf Chip-Ebene oder auf Chip-Carrier-Ebene ist mit einem solchen Meßplatz nur mit Hilfe von zusätzlichen Vorkehrungen möglich.

Der vorliegenden Erfindung liegt die Aufgabe zugrunde, einen Meßplatz nach dem Oberbegriff des Patentanspruchs 1 anzugeben, der die zerstörungsfreie Bestimmung der Eigenschaften von Mikrowellenschaltungen auf möglicht kleinen Substratflächen auch bei der Messung von quasi-planaren Schaltungen mit Anschlußleitungen in unsymmetrischer Mikrostreifen-Leitungs-Technik ermöglicht.

Diese Aufgabe wird erfindungsgemäß durch einen Meßplatz nach dem Patentanspruch 1 gelöst.

Ausgestaltungen und Vorteile der Erfindung sind in den Unteransprüchen, der Beschreibung und der Zeichnung angegeben.

Ein Meßplatz nach der Erfindung ermöglicht es, daß die Abmessungen der zu messenden Schaltungen (Abmessungen des Substrats, Abmessungen des Halbleiter-Chips, Abmessungen des Chip-Carriers usw.) für die Messung zu niedrigen Werten hin lediglich beschränkt sind durch die Querschnittsabmessungen der verwendeten Meßspitzen.

Das elektromagnetische Streufeld, die abgestrahlte Leistung und damit die elektromagnetische Verkopplung der Aperturfelder wird wesentlich durch die Querschnittsabmessungen im Vergleich zu der Wellenlänge der Grundwelle auf den Leitungen der Meßspitzen bestimmt. Die Erfindung ermöglicht es, Koaxialleitungs-Meßspitzen mit einem Innendurchmesser des Außenleiters von weniger als 0,7 mm zu verwenden. Solche Werte führen zu einer zulässigen minimalen Entfernung der Aparturen der verwendeten Meßspitzen von weniger als 1 mm, die die minimal zulässige Substratoberfläche bei der Messung bestimmt. Eine weitere Miniaturisierung der gesamten Meßanordnung wie auch des möglichen Meßobjekts sind durchführbar, so daß Abstände realisiert werden können, die eine direkte Messung von MMIC's oder von Transistoren zulassen.

Die Erfindung wird im folgenden anhand der Zeichnung näher erläutert.

FIG 1 zeigt die Draufsicht auf eine 4-Tor-Meßfassung.

FIG 2 zeigt einen Teil-Schnitt durch eine Meßfassung nach FIG 1.

FIG 3 zeigt einen Querschnitt eines Teils einer Meßfassung.

FIG 4 zeigt einen Schnitt durch einen Teil einer Meßfassung.

FIG 5 zeigt einen Schnitt durch einen Teil einer Meßfassung.

FIG 6 erläutert den Aparturbereich der Koaxialleitungs-Meßspitze für Meßobjekte mit koplanaren Anschlußleitungen.

FIG 7 zeigt eine Mikrostreifenleitungs-Meßspitze.

FIG 8 zeigt einen Querschnitt eines geschirmten Doppelleitungs-Systems.

FIG 9 zeigt einen Querschnitt einer planaren Mehrleiterstruktur.

FIG 10 zeigt eine Oberleiterstruktur einer angepaßten Meßspitze.

FIG 11 zeigt einen Längsschnitt durch ein Filter- oder Anpassungsnetzwerk in koaxialer Leitungstechnik.

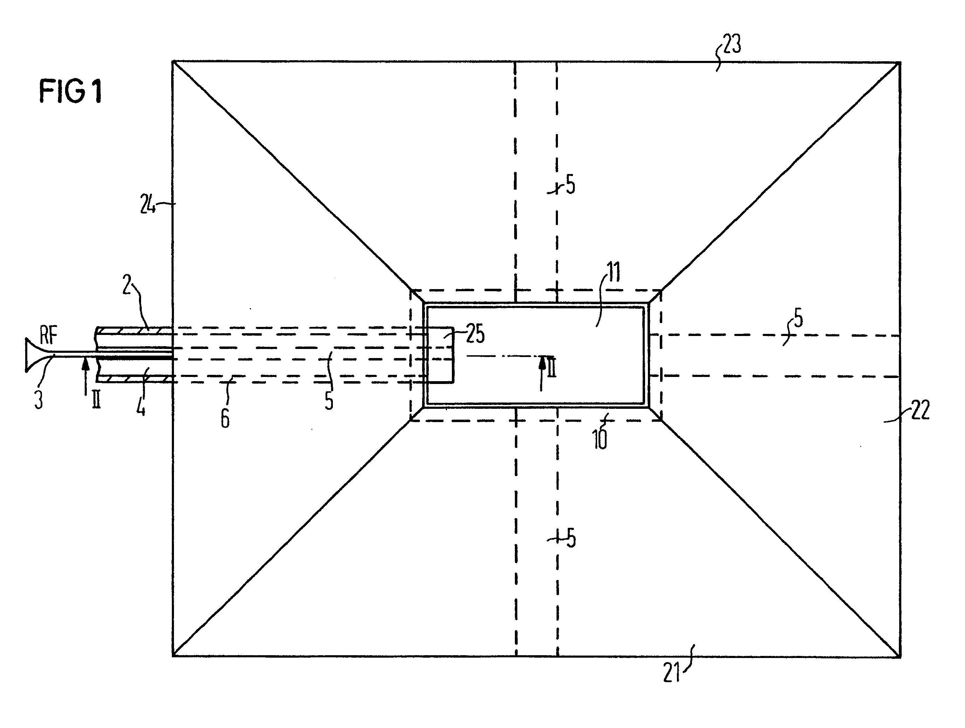

FIG 1 zeigt die Draufsicht (prinzipielle Anordnung) auf eine 4-Tor-Meßfassung einschließlich Koaxialleitungs-Mikrostreifenleitungs-Übergänge.

FIG 1 zeigt im Zentrum der Meßfassung das Meßobjekt (ohne Oberleiter) mit dem Substrat 11, das über Koaxialleitungen 5 (DC und RF) oder Meßspitzen 5 (DC) mit einem Meßsystem konventioneller Art, z. B. HP 8410/8510, verbunden ist.

Bei Verwendung von Koaxialleitungen für die Meßspitzen 5 weisen diese Koaxialleitungen einen Außenleiter 2, einen Innenleiter 3 und ein Dielektrikum zwischen Außenleiter 2 und Innenleiter 3, beispielsweise Teflon 4, auf. Die Meßspitzen 5 besitzen je nach Anwendung DC- oder RF-Zuführungen 6.

Die Meßspitzen 5 dienen zur Kontaktierung von Meßobjekten mit Leitungen in koplanarer und unsymmetrischer Leitungstechnik, deren Miniaturisierung durch die Erfindung ermöglicht wird. Ein Meßplatz nach der Erfindung besitzt im Prinzip einen zweiteiligen mechanischen Aufbau und ermöglicht die automatische Justierung der gesamten Anordnung.

Als Meßspitzen 5 werden unter anderem miniaturisierte offene Koaxialleitungen verwendet, z. B. Festmantel-Kabel. Diese Koaxialleitungen weisen an ihrem offenen Ende eine Nase 25 auf oder allein der Innenleiter 3 wird aus der Koaxialleitung herausgeführt, so daß entweder die Nase 25 oder der allein aus der Koaxialleitung 5 herausgeführte Innenleiter 3 in der Draufsicht nach FIG 1 mit der Fläche des Substrats 11 überlappt. Die Nase 25 kann aus Teflon 4 alleine bestehen. Die Nase 25 kann auch einen Teil des Außenleiters 2 und einen Teil des Teflons 4 aufweisen.

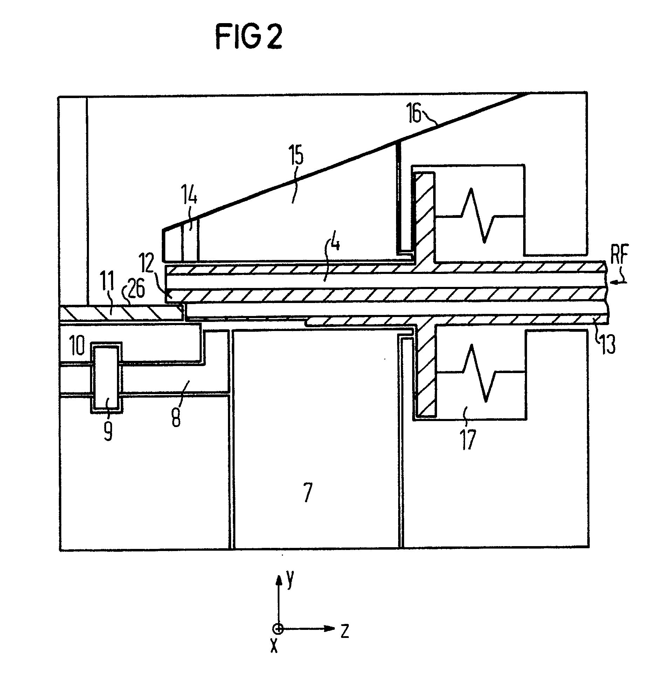

In den FIG 2 bis 5 werden konstruktive Einzelheiten des mechanischen Teils der Meßfassung sichtbar. Prinzipiell besteht mit einer Konstruktion nach der Erfindung die Möglichkeit, Schaltungen in Mikrostreifen-Leitungs-Technik zu messen, deren Fläche in die Größenordnung der zu prüfenden Chip-Carrier-Anordnungen kommt. Solche Chip-Carrier-Anordnungen können Abmessungen von etwa 2 x 5 mm² aufweisen. Die Schaltungen werden bei einer Messung nach der Erfindung nicht verändert oder zerstört, so daß sie nach der Prüfung direkt für die beabsichtigte Anwendung zur Verfügung stehen (zerstörungsfreie Messung im Mikrowellenbereich). Damit ist es nicht nur möglich, Stichproben aus Herstellungs-Chargen zu nehmen. Damit ist es möglich, jede gefertigte und zu verwendende Schaltung zu prüfen.

In den FIG 2 bis 5 ist jeweils zumindest ein Teil des Querschnitts einer Meßanordnung nach FIG 1 gezeigt. Die FIG 2 bis 5 erläutern insbesondere den Übergang zwischen den Meßspitzen und den Mikrostreifenleitungen auf dem Meßobjekt. Dieser Übergang kann mit einer miniaturisierten Koaxialleitung mit Festmantel ausgeführt werden. Als Koaxialleitung kann eine Semi-Rigid-Leitung verwendet werden, z. B. UT 34 mit einem Innenleiterdurchmesser von 0,200 mm und einem Innendurchmesser des Außenleiters von 0,66 mm. Der Innenleiter 3 wird durch die überstehende Außenleiter-Teflon-Nase 25 auf den Oberleiter der Mikrostreifenleitung auf einem Substrat 11 gedrückt. Das Substrat 11 kann aus $Al_2O_3$-Keramik bestehen mit einer Dicke von 10 mil und einer Oberleiterbreite einer 50 Ohm-Leitung von 0,248 mm. Die Außenseite des koaxialen Außenleiters 2 kann dabei auf der Carrier-Grundplatte 10 aufliegen. Die Carrier-Grundplatte kann aus CuMoCu bestehen. Die Stirnseiten in der Aperturebene der offenen Koaxialleitung liegen dabei bündig an der Kante des Substrats 11 an.

Die Chip-Carrier-Anordnung wird gehalten und justiert durch Paßstifte 9 in der Rückseite der Carrier-Grundplatte 10. Die Carrier-Grundplatte 10 kann zusätzlich durch eine Fassung (Carrier-Halterung) 8 fixiert werden. Die Carrier-Halterung 8 kann aus Teflon bestehen. Die miniaturisierten Koaxialleitungen 5 werden in ihren Querschnittsabmessungen so gewählt, daß einerseits aufgrund der verhältnismäßig kleinen Substratabmessungen eine elektromagnetische Verkopplung beider Aperturfelder verhindert wird, daß andererseits jedoch eine Wellenwiderstands-und Feldlinienbild-Anpassung beider Leitungsformen gewährleistet ist. Deshalb sollte die Differenz zwischen Innenleiter- und Außenleiter-Radius der Koaxialleitung etwa der Höhe des Substrats 11 entsprechen, um zusätzliche Anpassungs-Netzwerke zu vermeiden. Die Koaxialleitung 5 kann winklig zur Carrier-Grundfläche angeordnet werden, um den Kontakt zwischen Mikrostreifenleitungen und Meßspitzen zu verbessern.

Zur Verminderung der elektromagnetischen Rückwirkung der Wände der Meßfassung ist eine um einen spitzen Winkel geneigte Konstruktion geeignet. Dabei sollte die Oberfläche der Meßfassung mit einem geeigneten Dämpfungsmaterial beschichtet sein.

Bei Innenleitern 3 mit kleinen Querschnittsabmessungen wird die Nase 25 oder ein zusätzlicher Mechanismus, z. B. ein Paßstift 9 oder eine Halterung 8 aus dielektrischem Material niedriger Permittivität vorgesehen, um die für eine reproduzierbare Kontaktierung zwischen Meßobjekt und Meßspitzen notwendige Justierung zu gewährleisten. Die Meßspitzen 5, deren Art und Anzahl je nach Meßobjekt und Kontaktierung (DC und RF) variieren können, sind gemeinsam oder einzeln auf einer oder mehreren Halterungen montiert. In Längsrichtung sind die Meßspitzen federnd und verdrehsicher gelagert. Der Übergang von den Meßspitzen zum weiteren Meßsystems erfolgt durch geeignete koaxiale Anordnungen.

Das signifikante Streufeld am offenen Ende der Meßspitzen 5 breitet sich in einem Volumenbereich aus, dessen Radius etwa dem 2-3fachen des Innenradius des Außenleiters 2 entspricht. Je nach Lage der Meßspitzen zueinander wird dadurch die minimale Entfernung der Meßspitzen festgelegt. Dabei ist jeweils vorausgesetzt, daß die Wellenlänge der Grundwelle in der Koaxialleitung 5 sehr viel größer ist als alle Querschnittsabmessungen und daß der Innenleiter 3 bzw. Oberleiter der Meßspitzen lediglich eine solche Länge über die Aperturebene der Meßspitze hinaus aufweist, welche sehr klein ist im Vergleich zur Wellenlänge der Grundwelle, um zusätzliche Abstrahlung in diesem Bereich zu vermeiden. Diese Bedingung ist aber bei der beabsichtigten Anwendung der Meßfassung und im geplanten Frequenzbereich bis zu 18 GHz und oberhalb von 18 GHz immer erfüllt, da die Dicke des Substrats etwa der Differenz von Innenleiterradius und Außenleiterradius der Koaxialleitung 5 entspricht, um eine Widerstands- und Feldbildanpassung im Übergangsbereich zwischen Meßobjekt und Meßspitze zu gewährleisten. Bei festen Materialien kann die Meßanordnung porportional zur Betriebsfrequenz verkleinert bzw. vergrößert werden (Verlustlosigkeit vorausgesetzt), ohne die Eigenschaften der Anordnung zu beeinflussen. Dabei bleibt nur noch der näherungsweise konstante Einfluß der mechanischen Herstellungstoleranzen zu berücksichtigen.

Grundlage für einen Meßplatz nach der Erfindung kann ein konventioneller Spitzenmeßplatz sein, der in erfindungsgemäßer Weise umgebaut wird. Damit ist ein Mikroskop vorhanden, mit dem die Justierung des Meßobjektes, das bedeutet die Justierung des Oberleiters 26 auf dem Meßobjekt und dem Innenleiter 12 der Koaxialleitung, überprüft werden kann. Die horizontale (x-z-Richtung, FIG 2) Bewegung erfolgt z. B. manuell mit Hilfe einer Mikrometerschraube oder rechnergesteuert über einen entsprechenden Support, die vertikale (y-Richtung) Bewegung erfolgt mit einer geeigneten Anordnung. Zusätzlich können die Koaxialleitungen in z-Richtung federnd, aber verdrehsicher bewegt werden. Dadurch können die Eigenschaften des Übergangs zwischen Koaxialleitung 5 und Mikrostreifenleitung verbessert werden. Die Kontaktierung des Meßobjekts erfolgt im Hochfrequenzbereich und im DC-Bereich über die Koaxialleitungen 5 oder im DC-Bereich über gebräuchliche Meßspitzen 5, soweit diese Meßspitzen 5 die Funktion des Meßobjekts nicht beeinträchtigen. Die Meßanordnung ist geeignet, vollständige, fehlerkorrigierte ("on carrier", "on Chip" Kalibrierung) vektorielle Messungen an Schaltungen auf möglichst kleiner Substratfläche durchzuführen.

FIG 2 zeigt eine verdrehsichere Kabelführung 17 mit auswechselbaren Kabeln. Die auswechselbaren Kabel sind in Längsrichtung federnd angeordnet. Die Meßfassung 15 besitzt einen Paßstift 14, um einen Andruck des koaxialen Innenleiters 12 auf dem Oberleiter 26 des Substrats 11 zu ermöglichen. Die Meßfassung 15 besitzt an ihrer Oberfläche Dämpfungsmaterial 16. Das Koaxialkabel besitzt einen SMA-Anschluß 13. Die Meßanordnung nach FIG 2 besitzt ein Podest 7.

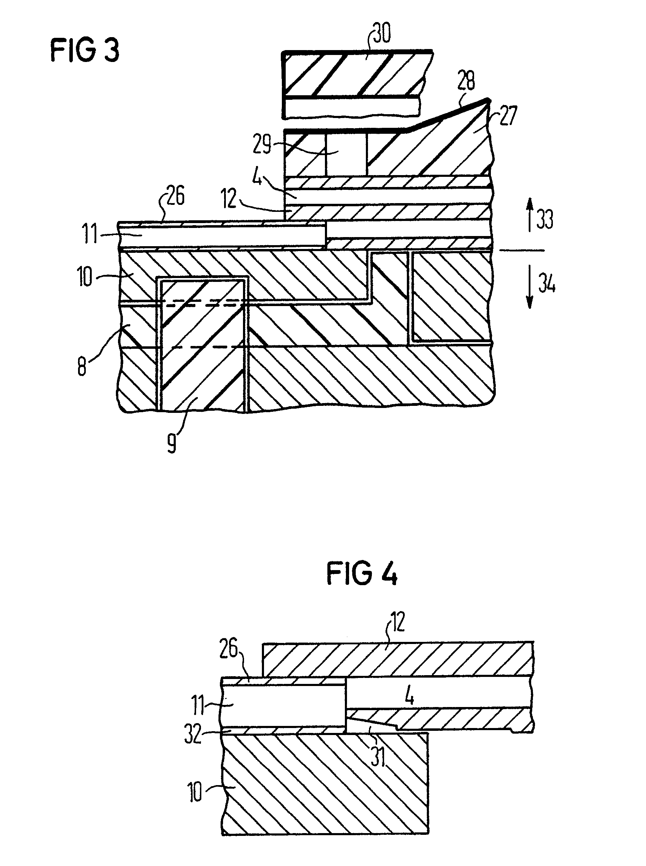

FIG 3 zeigt einen Querschnitt eines Teils einer Meßfassung ähnlich zur Meßfassung nach FIG 2. Dabei ist deutlich zu sehen, daß der Paßstift 9 zur Justierung des Chip-Carriers 10 dient. Die Meßfassung 27 besitzt dabei an ihrer Oberfläche eine Widerstandsschicht 28. Zur Fixierung der Koaxialleitung 5 und zum Andrücken des koaxialen Innenleiters 12 dieser Koaxialleitung 5 auf die Oberleitermetallisierung 26 auf dem Substrat 11 dient die Andruckmechanik 29, 30, die einen Paßstift 30 beispielsweise aus Teflon und einen Paßstift 29, der innerhalb der Meßfassung 27 angeordnet ist, aufweist.

Die Anordnung nach FIG 3 besitzt einen oberen Teil 33 und einen unteren Teil 34. Der obere Teil 33 besteht aus dem Sondenaufbau und aus dem oberen Teil der Meßanordnung. Der untere Teil 34 der Meßanordnung ist auf dem Podest 7 des Spitzenmeßplatzes angeordnet.

FIG 4 zeigt im Schnitt eine weitere Möglichkeit für einen Übergang zwischen einer Koaxialleitung und einer Mikrostreifenleitung. Der koaxiale Innenleiter 12 kontaktiert dabei die Oberleitermetallisierung 26 auf dem Substrat 11. Die Unterseite des Substrats 11 kann eine Metallisierung 32 aufweisen. Zwischen dem Substrat 11 und dem Außenleiter der Koaxialleitung wird über den Außenleiter-Keramik-Kontakt 31 ein elektrischer Kontakt hergestellt.

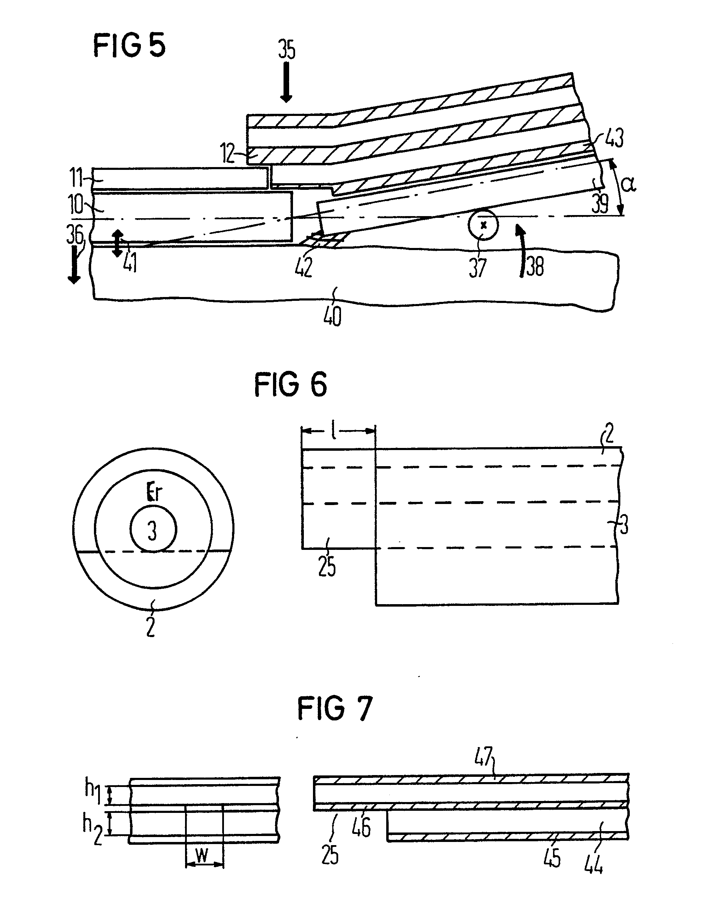

FIG 5 zeigt eine weitere Version der Andruckmechanik zwischen der Meßspitze und dem Meßobjekt. Der Innenleiter 12 und der Außenleiter 43 der Koaxialleitung werden auf die Chip-Carrier-Anordnung 10, 11 gepreßt, indem der zweite Teil der Meßfassung 39 winklig angeordnet wird. Dieser zweite Teil der Meßfassung 39 ist verstellbar angeordnet, um den mechanischen Andruck der Koaxialleitung gegen das Meßobjekt zu Beginn einer Messung einzustellen. Die Chip-Carrier-Anordnung 10, 11 ist dabei in Richtung der Pfeile 41 federnd gelagert. Auch der erste Teil der Meßfassung 40 ist in Richtung der Pfeile 41 federnd ausgebildet. Der erste Teil der Meßfassung 40 und der zweite Teil der Meßfassung 39 sind an geeigneter Stelle mit Drehgelenken 42 verbunden. Die dabei auftretende Knickstelle zwischen dem ersten Teil der Meßfassung 40 und dem zweiten Teil der Meßfassung 39 ist in FIG 5 übertrieben dargestellt zur Verdeutlichung des Prinzips.

Die Druckrichtung, in der die Koaxialleitung gegen das Meßobjekt gedrückt wird, ist mit 35 bezeichnet. Bei einer Meßanordnung nach FIG 5 ergibt sich eine Zugrichtung 36. Die Meßanordnung nach FIG 5 besitzt eine drehbare Befestigung 37, um die herum der zweite Teil der Meßfassung 39 in der Bewegungsrichtung 38 gedreht werden kann.

FIG 6 zeigt den Aperturbereich koaxialer Meßspitzen 5, wenn das Meßobjekt eine Anschlußleitung in koplanarer Leitungstechnik aufweist. Die Länge 1 der Nase 25 ist dabei variabel an das jeweilige Meßobjekt anpaßbar. Für Meßobjekte mit Anschlußleitern in unsymmetrischer Mikrostreifenleitungs-Technik ist der Aperturbereich koaxialer Meßspitzen in den FIG 2 bis 5 dargestellt.

FIG 7 zeigt die Gesamtanordnung einer planar aufgebauten Meßspitze. Diese Meßspitze besteht aus einer Grundstruktur aus Trägermaterial und Grundmetallisierung 45, auf die eine weitere dielektrische Schicht 44 mit dem Oberleiter 46 aufgebracht ist. Die Gesamtstruktur dieser Meßspitze ist unter Umständen abgeschirmt durch eine weitere Metallisierung 47. Die Gesamtstruktur der Meßspitze kann eine Nase 25 aufweisen. Der rechte Teil von FIG 7 ist ein Schnitt durch die Mitte des linken Teils von FIG 7. FIG 7 zeigt eine Mikrostreifenleitungs-Meßspitze für Meßobjekte mit Anschlußleitungen in unsymmetrischer Mikrostreifenleitungs-Technik. In modifizierter Form ist eine solche Mikrostreifenleitungs-Meßspitze auch für ein Meßobjekt mit Anschlußleitungen in koplanarer Leitungstechnik geeignet.

Der Übergang zum Meßsystem erfolgt bei Verwendung einer Meßspitze in Mikrostreifenleitungstechnik über einen geeigneten Mikrostreifenleitungs-Koaxialleitungs-Übergang. Die Meßspitzen können ähnlich zu den Meßspitzen nach den FIG 2 bis 5 beweglich gelagert sein.

Mit jeweils geringer Modifizierung der Grundstruktur nach FIG 7 lassen sich Meßspitzen in koplanarer oder unsymmetrischer Mikrostreifenleitungstechnik oder in Triplate-Technik herstellen.

Die Meßspitzen sind unabhängig von der Anwendung in der Meßanordnung prinzipiell geeignet zur Messung von integrierten Schaltungen auf Chip-Ebene, welche fest in einer hybrid aufgebauten Gesamtschaltung implementiert sind.

Aufgrund der Doppelleitungsstruktur sind diese Strukturen prinzipiell in einem weiten Frequenzbereich von der Frequenz Null an zu verwenden.

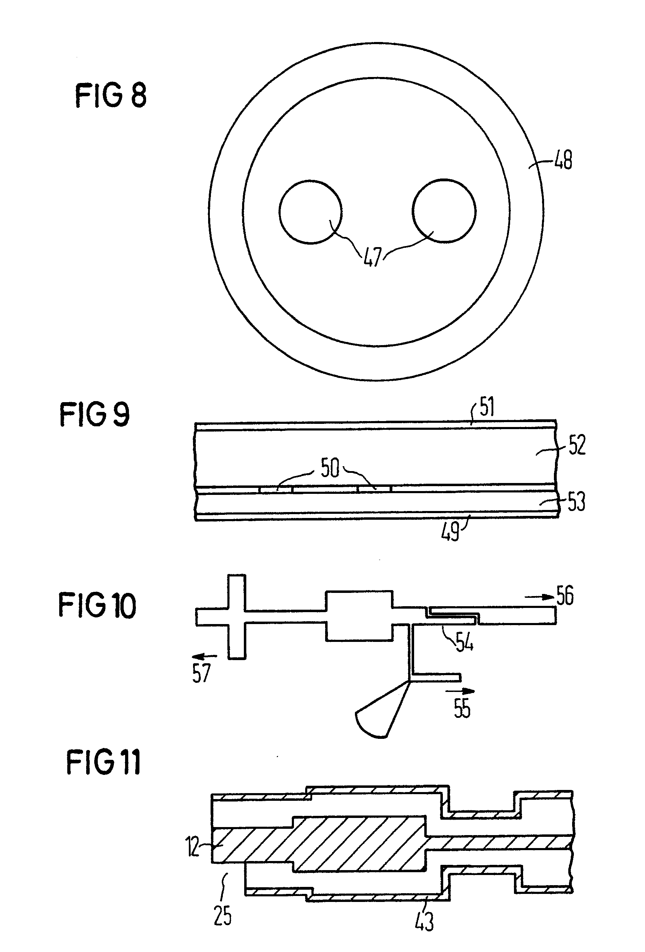

FIG 8 und 9 zeigen Mehrleiter-Strukturen. Die Meßspitzen 5 können mehrere Innenleiter bzw. Oberleiter aufweisen.

FIG 8 zeigt einen Querschnitt eines geschirmten Doppelleitungssystems (Dreileiteranordnung) mit zwei Inneleitern 47 und einem Außenleiter 48. FIG 9 zeigt einen Querschnitt (Aperturbereich) einer planaren Mehrleiterstruktur mit einer Grundmetallisierung 49, mehreren Oberleitern 50, einer Schirmung 51 und zwei Dielektrika 52, 53.

FIG 10 und 11 zeigen koaxiale und planare Filterstrukturen. In die Meßspitzen 5 können Netzwerke integriert werden, z. B. zur Entkopplung der Hochfrequenzleistung, zur Anpassung, Dämpfung und Filterung von Oberwellen oder ähnlichem. Entsprechende Netzwerke können auch auf der Meßobjekt-Halterung aufgebracht werden. FIG 10 zeigt eine Oberleiterstruktur einer angepassten Meßspitze 5 mit DC-Block (Kondensator) 54 und DC-Versorung 55 in planarer Leitungstechnik. Der Pfeil 56 zeigt zum Meßsystem und der Pfeil 57 zum Meßobjekt.

Bild 9 zeigt einen Längsschnitt durch ein Filter- oder Anpassungsnetzwerk in koaxialer Leitungstechnik (Prinzip). Die Meßspitze nach FIG 11 besitzt einen Innenleiter 12, einen Außenleiter 43 und eine Nase 25. Die Meßanordnung nach der Erfindung kann für jeden Übergang zwischen Meßobjekt und Meßfassung aus zwei Teilen bestehen, die miteinander über ein Drehgelenk verbunden sind (FIG 2 bis 5). Der erste Teil besteht aus dem für alle Meßspitzen gleichen Meßobjektträger und dem weiteren in den drei Raumrichtungen (x, z: kontinuierliche Bewegung; y: zwei Zustände) beweglich angeordneten unteren Teil. Der zweite Teil besteht aus der Halterung für die jeweilige Meßspitze und dem gesamten oberen Teil, der entweder aus einem Material hergestellt ist, das möglichst wenig Rückwirkungen auf die Betriebseigenschaften der Meßanordnung hat, oder das mit einem geeigneten Dämpfungsmaterial überzogen ist.

Die Meßspitze ist fest mit dem zweiten Teil verbunden. Die Grundplatte 10 des Meßobjektträgers hat auf kürzestem Wege mit der Grundmetallisierung 32 der quasi-planaren Schaltung elektrischen Kontakt.

Die Halterung 8 dsr Meßobjektträgers besteht aus einem Material, dessen Eigenschaften möglichst wenig Rückwirkungen auf das Betriebsverhalten der Anordnung haben, z. B. aus einem Dielektrikum mit niedrigem Wert der Permitivitäts-Zahl, welches noch mit einem geeigneten Dämpfungsmaterial überzogen ist. Durch zusätzliche Maßnahmen, wie z. B. Paßstifte 9 in der Carrier-Grundplatte 10, ist das Meßobjekt genau fixierbar. Der Meßobjektträger ist federnd gelagert, um einerseits eine verbesserte Kontaktierung des Übergangs zwischen Meßobjekt und Meßspitze, andererseits einen Übergang mit konstanter Andruckkraft (Federkonstante) zu gewährleisten. Der Meßobjektträger kann in der x-z-Ebene und auch in der y-Richtung rechnergesteuert, z. B. entsprechend einer Justierungsvorschrift, mit Hilfe eines Koordinatentisches bewegt werden.

In FIG 1 ist pro Meßspitze 5 jeweils eine Meßfassung 21 bis 24 beweglich bezüglich des Meßobjekts angeordnet. Die bewegliche Lagerung der zwei Teile der Meßanordnung der Meßspitze 5 über ein Drehgelenk an einer Stelle, die nicht das Betriebsverhalten der Anordnung beeinflußt, in Verbindung mit der Beweglichkeit der Meßspitzen 5 in Längsrichtung dieser Meßspitzen und über ein weiteres Drehgelenk und in Verbindung mit der federnden Halterung von Meßspitzen und Meßobjekt, gewährleistet durch manuelle oder automatische Bewegung der Anordnung in y-Richtung die optimale Kontaktierung im Bereich des Überganges von Meßobjekt-Leitung und den jeweiligen Meßspitzen 5 in deren Aperturbereich. Die Meßobjekt-Leitung kann dabei eine unsymmetrische Mikrostreifenleitung oder eine Koplanarleitung mit/ohne Grundmetallisierung sein. Darüber hinaus ist auch die mechanisch ungekoppelte Zuordnung der zwei Teile der Meßanordnung möglich. Beide Anordnungen ermöglichen eine reproduzierbare, schnelle und rechnergesteuerte Justierung. Zur Kontrolle der Justierung des Innenleiters der Koaxialleitung bzw. des Oberleiters planarer Meßspitzen auf dem Oberleiter der planaren Leitung des Meßobjekts dient ein Mikroskop (manuelle Justierung) oder ein elektrisches Signal, das aus dem Reflexions- oder Transmissions-Verhalten der Schaltung, einer Referenz-Struktur gemeinsam auf dem Meßobjekt oder auf der Meßobjekt-Halterung, oder aus dem Ausgangssignal einer geeigneten konventionellen Einrichtung abgeleitet werden kann (automatische Justierung). Dieses elektrische Signal muß nicht unbedingt aus dem Verhalten einer planaren Struktur im Mikrowellenbereich abgeleitet werden. Dazu eignen sich auch optische oder elektronische Einrichtungen konventioneller Art. Im Mikrowellengebiet kann dazu beispielsweise das Reflexions- bwz. Transmissions-Verhalten einer Mikrostreifenleitung in Abhängigkeit von der Justierung oder auch das Anregungsverhalten einer Resonanzstruktur herangezogen werden.

Eine Meßanordnung nach der Erfindung kann Teil eines konventionellen rechnergesteuerten Meßsystems zur Bestimmung des analogen oder digitalen elektrischen Verhaltens der Meßobjekte (z.B. Netzwerk-Analysator, TDR-Meßplatz, Rausch-Meßplatz oder ähnlichem) sein. Diese Kombination aus Meßsystem und mechanischer Meßanordnung mit rechnergesteuerter Justierung des Meßobjekts erlaubt die zerstörungsfreie, vollständig rechnergesteuerte und fehlerkorrigierte (Kalibrierungs-Verfahren) Messung von quasiplanaren Schaltungen auf kleinen Substratflächen.

Die Erfindung ermöglicht eine reproduzierbare Kontaktierung, geringen Verschleiß der Meßspitzen, automatische Steuerung des Justiervorganges bei kleinen Querschnittsabmessungen der Meß spitzen und bei kleinen Oberleiterbreiten der Mikrostreifenleitungen auf dem Meßobjekt, sowie Meßvorgänge in kurzer Zeit. Die Erfindung ermöglicht auch bei einer manuell durchgeführten Messung ein schnelles Auswechseln der Meßobjekte und eine Anwendung in der Serienmessung.

Bei sehr kleinen Breiten der Oberleiter (entsprechend kleinen Dicken des Substrats 11) ist eine automatische Justierung vorteilhaft.

Unterhalb einer bestimmten Breite des Oberleiters des Meßobjekts ist es vorteilhaft, eine Meßspitze in planarer Technik zu verwenden. Die Herstellungstoleranzen der koaxialen Meßspitzen wirken sich nämlich mit zunehmender Miniaturisierung immer stärker auf das elektrische Verhalten aus, gekennzeichnet durch den Leitungswellenwiderstand und das Phasenmaß der Grundwelle. Hinzu kommt das Verhalten des Überganges von der Meßspitze zum Meßsystem (Stehwellenverhältnis auf der Leitung). Bei der Erfindung erfolgt die Kontaktierung zwischen Meßobjekt und Meßspitze entweder durch die Bewegung der Meßspitze, durch die Bewegung der Meßobjekt-Halterung oder kombiniert durch Bewegungen der Meßspitze und der Meßobjekt-Halterung in einer je Meßspitze zweiteiligen, mechanischen gekoppelten oder mechanisch ungekoppelten Anordnung nach den FIG 2 bis 5.

Die Meßspitzen können eine Nase 25 aufweisen. Eine Andruckvorrichtung sorgt für die Justierung des koaxialen Innenleiters-bzw. des Oberleiters einer planar aufgebauten Meßspitze. Der Andruck der Meßspitzen auf die Leitungen des Meßobjekts kann z. B. durch definierte Gewichte oder Federkonstanten, die an geeigneter Stelle an der zweiteiligen Mechanik wirksam werden, sehr genau definiert werden.

Alle Meßspitzen können unabhängig voneinander oder in Gruppen oder alle gemeinsam bewegt werden.

Die Meßspitzen dienen zur Kontaktierung ab der Frequenz Null.

In der Meßanordnung können auch konventionelle Meßspitzen eingesetzt werden, wie sie von Spitzenmeßpläten bekannt sind, soweit sie nicht das Verhalten der Schaltung meßbar beeinflussen.

Unabhängig von der Anwendung in der vorgeschlagenen Meßanordnung können die Meßspitzen und deren Halterung und Justierung auch zur direkten Prüfung von integrierten Schaltungen und Chip-Anordnungen innerhalb einer Gesamtschaltung, z. B. GaAs-Chip-Anordnungen auf Durchkontaktierungen oder Chip-Carriers verwendet werden.

Aus den gemessenen Signalen am Meßobjekt oder an einem Referenzobjekt kann eine Vorschrift zur automatischen Steuerung des Justiervorganges und des Meßvorganges abgeleitet werden. Daraus ergibt sich die automatisierte Justierung des Meßobjekts oder der Meßspitzen (getrennt oder gemeinsam). Die Referenzstruktur kann auf dem Meßobjekt oder auf der Halterung des Meßobjekts angebracht werden. Das Steuersignal zur Bewegung der Anordnung kann mit optischen oder elektronischen Netzwerken oder mechanischen Vorrichtungen gewonnen werden.

Die Erfindung ermöglicht die Kontaktierung zwischen Meßobjekt und Meßspitze mit Hilfe einer zweiteiligen mechanischen Anordnung für jeden Übergang zwischen Meßobjekt und Meßspitze.

## Ansprüche

1. Meßplatz für ein Mikrowellenbauelement, mit einem Träger (10) für das Mikrowellenbauelement und mit mindestens einer Meßspitze (5), **dadurch gekennzeichnet,** daß die räumlichen Positionen der mindestens einen Meßspitze (5) in den drei Raumrichtungen bezüglich der räumlichen Position des Trägers (10) veränderbar und justierbar sind.

2. Meßplatz nach Anspruch 1, **dadurch gekennzeichnet,** daß die räumliche Position des Trägers (10) in drei Raumrichtungen veränderbar und justierbar ist.

3. Meßplatz nach Anspruch 1 oder 2, **dadurch gekennzeichnet,** daß die räumliche Position mindestens einer Meßspitze (5) in drei Raumrichtungen veränderbar und justierbar ist.

4. Meßplatz nach einem der Ansprüche 1 bis 3, **gekennzeichnet durch** eine Einrichtung zur automatischen Justierung von Träger (10) und/oder Meßspitzen (5).

5. Meßplatz nach einem der Ansprüche 1 bis 4, **gekennzeichnet durch** mindestens eine Meßspitze (5) in Form einer Koaxialleitung.

6. Meßplatz nach Anspruch 5, **dadurch gekennzeichnet,** daß der Koaxialaußenleiter (43) auf dem Träger (10) aufliegt.

7. Meßplatz nach einem der Ansprüche 1 bis 6, **dadurch gekennzeichnet,** daß wenigstens eine Meßspitze (5) eine Ausgestaltung zur Ausübung eines mechanischen Druckes auf das Mikrowellenbauelement aufweist.

8. Meßplatz nach einem der Ansprüche 1 bis 7, **dadurch gekennzeichnet,** daß wenigstens eine Meßspitze (5) über ein Drehgelenk (37) drehbar gelagert ist.

9. Meßplatz nach einem der Ansprüche 1 bis 8, **dadurch gekennzeichnet,** daß die Meßspitzen (5) zeitlich in beliebiger Kombination bewegbar sind.

10. Meßplatz nach einem der Ansprüche 1 bis 9, **gekennzeichnet durch** eine Einrichtung zur direkten Prüfung eines Halbleiterbauelements innerhalb einer Mikrowellenschaltung.

11. Meßplatz nach einem der Ansprüche 1 bis 10, **dadurch gekennzeichnet,** daß wenigstens eine Meßspitze (5) eine Mehrleiterstruktur aufweist.

12. Meßplatz nach einem der Ansprüche 1 bis 11, **gekennzeichnet durch** eine Integration eines Netzwerks in wenigstens eine Meßspitze (5).

FIG 1

EP 0 419 725 A1

EP 0 419 725 A1

# FIG 2

9

FIG 3

FIG 4

# FIG 5

# FIG 6

# FIG 7

FIG 8

FIG 9

FIG 10

FIG 11

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| Y | FR-A-2 201 474 (R.T.C.)<br>* Fig.; Seiten 6,7 *<br>--- | 1-9 | G 01 R 1/067 |
| Y | US-A-3 590 372 (IBM)<br>* Fig. 4,8; Spalte 4, Zeile 55 - Spalte 5, Zeile 30; Spalte 7, Zeilen 36-57 * &<br>DE-A-1 964 522<br>--- | 1-9 | |
| A | US-A-4 056 777 (ELECTROGLAS)<br>----- | | |

**RECHERCHIERTE SACHGEBIETE (Int. Cl.5)**

G 01 R

Der vorliegende Recherchenbericht wurde für alle Patentansprüche erstellt

| Recherchenort | Abschlußdatum der Recherche | Prüfer |
|---|---|---|
| DEN HAAG | 30-05-1990 | HOORNAERT W. |

EPO FORM 1503 03.82 (P0403)